# EUROPEAN PATENT SPECIFICATION

(11) **EP 1 180 923 B1**
(45) Date of publication and mention of the grant of the patent: **26.07.2006**
(21) Application number: 00306960.6
(22) Date of filing: 15.08.2000
(51) Int. Cl.: H05K 7/20, H05K 7/16

(54) **Cabinet with top mounted equipment tray**
Gestell mit oben montierter Tragschale für eine Anlage
Armoire sur le dessus de laquelle est monté un plateau supportant un équipement

(43) Date of publication of application: 20.02.2002
(73) Proprietor: Cannon Technologies Ltd., New Milton, Hampshire BH25 5NU (GB)
(72) Inventor: Reddicliffe, Edward A., New Milton, Hampshire BH25 5NU (GB)
(74) Representative: Brunner, Michael John

(56) References cited:
- EP-A- 0 498 073
- EP-A- 0 949 856
- DE-U- 8 914 551

## Description

The invention relates to a cabinet having a top mounted slidable equipment tray, particularly for the mounting of cooling fans, to enable access to the fans to be achieved simply and quickly.

So-called rack-mounting cabinets are increasingly used to support computer and like electrical equipment and it is often necessary to provide cooling fans. These are often mounted in a tray which can be lowered into the top of the cabinet or offered up to the top from the inside and removed therefrom for replacement, servicing etc. of the fans (see EP-0 949 856).

However, increasingly, space is at a premium and therefore cabinets extend close to the ceiling of the room in which they are located. Sometimes, there may be other equipment close to the top of the cabinet. In both cases, access may not be possible through the top of the cabinet and therefore vital equipment may need to be removed from inside the cabinet in order to lower the fan tray for removal. Removing active equipment from the cabinet can be critical to the operation of the equipment within the cabinet.

Equipment other than fans may be similarly mounted in a cabinet top. However, particularly when fans are so mounted, and the cabinet is to extend close to the ceiling, it is desirable to provide head space above the fan and for the cabinet to contain a roof with sideways opening vents through which warmed air may be forced out by the fans.

In order to simplify the installation and removal of electrical equipment such as fans in such cabinets, the present invention provides an equipment cabinet having a top which includes a substantially horizontal equipment tray removable from the top of the cabinet, characterised by a support mechanism by means of which the tray is slidably removable through a side member of the cabinet from an operative position within the cabinet to a non-operative, withdrawn position outside the cabinet, the support mechanism causing the tray to be lifted upwardly as it is moved from the operative position into the withdrawn position.

The side member of the cabinet through which the tray is withdrawn may be part of a roof or top member of the cabinet or may simply be the space between vertical upright members of the cabinet and may be disposed either in front, a side or the rear of the cabinet. Preferably, however, when the cabinet includes a roof, a side member of the roof includes an access opening through which the tray can be slidably withdrawn.

The cabinet preferably includes a cam surface on one of the trays or the cabinet which is arranged to engage a cam follower surface on the other to cause the tray to be lifted as it moved outwards. The cam surface may be a ramp inclined to the horizontal.

Advantageously, a stop mechanism is provided for preventing the complete disconnection of the tray from the cabinet and the stop mechanism may include one or more lugs engagable with the sides of the cabinet. Such a stop mechanism may enable the tray to be supported in a substantially vertical position outside the cabinet, hanging down from the top of the cabinet.

By causing the tray to be lifted as it pulled outwards, maximum use can be made of the head space at the top of the cabinet, particularly when the tray houses electrical fans and head space is required in order to allow the fans to operate effectively to remove heated air from within the cabinet and cause it to flow through vents in the roof.

The tray may include an electrical connector or connectors which are automatically engaged with mating connectors on the cabinet when the tray is moved in its operative position. One or more electrical fans may be mounted on the tray for removal with the tray as desired. Providing for automatic connection/disconnection provides a safety measure for the servicing engineer to avoid electrical shock or trapping of fingers and like in operating fans.

One example of a cabinet construction in accordance with the present invention will now be described with reference to the accompanying drawings in which:
Fig. 1 is a view of the top of an electrical cabinet showing a fan tray in two positions, an operative position and a partially withdrawn position;
Fig. 2 is a plan view of the top of the cabinet;
Fig. 3 is a side view of the tray; and
Fig. 4 is a front view of the cabinet with the tray withdrawn and in a servicing position in the front of the cabinet.

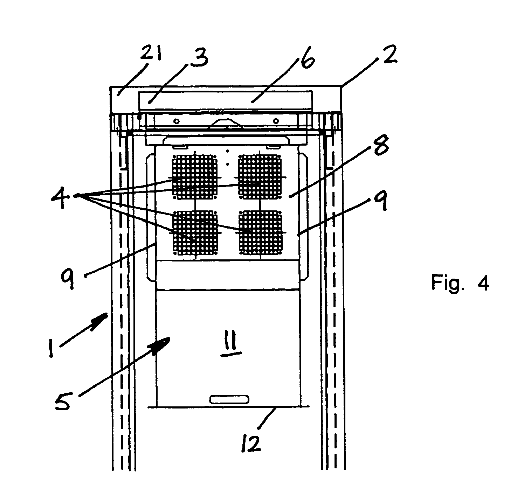

The cabinet 1 shown in the drawings is intended for housing rack-mounted computer equipment or the like which requires cooling. The cabinet 1 has a top member 2 which provides head space 3 to allow outward flow of warmed air from within the cabinet under the action of fans 4, four of which are shown mounted on a tray 5. The top member or roof 2 has a front access window 6 (see Figure 4) in the front side 21 of the top 2 and houses the tray 5 on rails 7. The tray has a fan-mounting surface 8, a pair of side walls 9 and an inclined ramp or cam surface 10 extending upwardly and forwardly to a front portion 11 of the tray which may have an upwardly or downwardly extending front flange 12, 12' arranged to act as an abutment or stop when the tray is pushed back into the top of the cabinet 1. Front vents may also be provided in the top member 2.

In use, the tray 5 is pulled forward and the ramp 10 engages the internal top front edge 14 of the cabinet and thus lifts the try upwards to enable it to slide through the front access window 6.

Rear lugs 13 extending sideways from the tray 5 are used to prevent the tray from being removed completely from the front of the cabinet, but allow it to be pulled forward and then swung down into the position shown in Fig. 4, at which the fans can be readily accessed for servicing, replacement or the like.

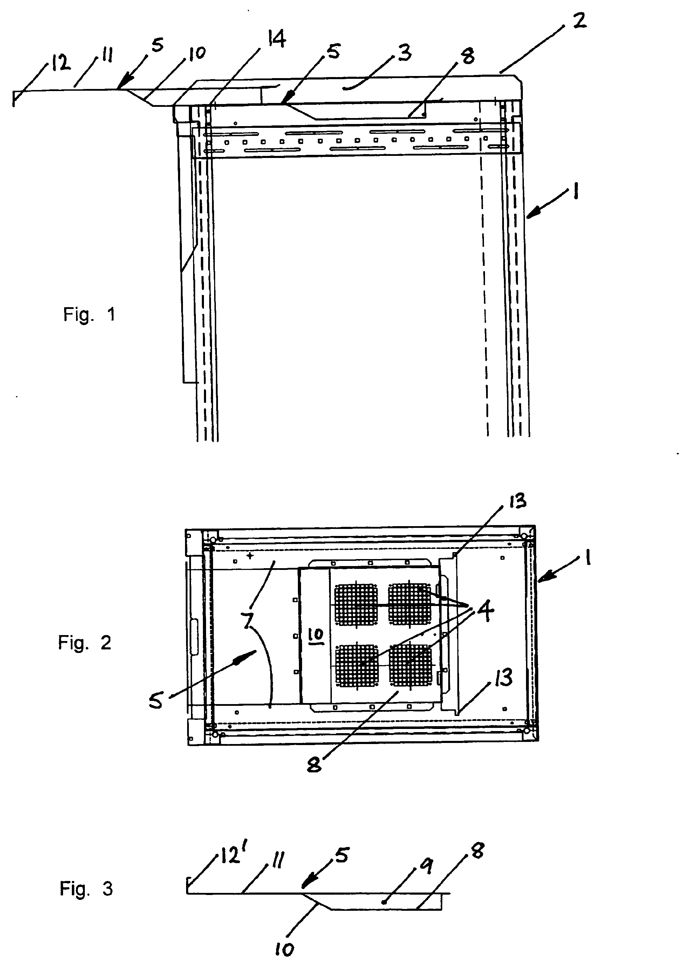

An edge connector mechanism or the like (not shown) can be used to connect the fans 4 electrically to a power source (not shown) within the cabinet when the tray is pushed fully home into the operative position shown in Fig. 2. The fan 5 may be held into position by a locking plate or similar arranged to grip one or more sides of each fan to hold the fans in position on the tray 5. Alternatively, as is conventional, four bolts or screws, one at each corner of the fan housing, may be used for this purpose.

## Claims

1. An equipment cabinet (1) having a top (2) which includes a substantially horizontal equipment tray (5) removable from the top of the cabinet, **characterised by**
a support mechanism (7,10) by means of which the tray (5) is slidably movable through a side member of the cabinet from an operative position within the cabinet to a non-operative, withdrawn position outside the cabinet, the support mechanism causing the tray to be lifted upwardly as it is moved from the operative position into the withdrawn position.

2. A cabinet according to claim 1, wherein the top of the cabinet (1) includes an access opening (3) in its side, through which the tray (5) can be slidably withdrawn.

3. A cabinet according to claim 1 or claim 2, wherein the support mechanism includes a cam surface (10) on one of the tray (5) or the cabinet (1) and arranged to engage a cam follower surface (14) on the other to lift the tray as it is moved outwards.

4. A cabinet according to claim 3, wherein the cam surface includes a ramp surface (10) inclined to the horizontal on one of the tray (5) or the cabinet (1) and arranged to engage the other to lift the tray as it is moved outwards.

5. A cabinet according to any of claims 1 to 4, including a stop mechanism (13) for preventing the complete disconnection of the tray (5) from the cabinet (1).

6. A cabinet according to claim 5, wherein the stop mechanism includes one or more lugs (13) engageable with the sides of the cabinet.

7. A cabinet according to claim 5 or claim 6, wherein the stop mechanism (13) enables the tray to be supported in a substantially vertical position outside the cabinet, depending from the top of the cabinet.

8. A cabinet according to any of claims 1 to 7, wherein the tray includes an electrical connector which is automatically engaged with a mating connector on the cabinet when the tray is moved into its operative position.

9. A cabinet according to any of claims 1 to 8, wherein the tray (5) includes one or more electrical components (4) disposed thereon.

10. A cabinet according to claim 9, wherein the tray (5) includes one or more fans (4) disposed thereon.

## Patentansprüche

1. Geräteschrank (1) mit einem Oberteil (2), das eine im wesentlichen horizontale Gerätetragschale (5) umfasst, die von dem Oberteil des Schranks entfernbar ist, **gekennzeichnet durch**
einen Haltemechanismus (7, 10), **durch** den die Tragschale (5) gleitend **durch** ein Seitenelement des Schranks aus einer Betriebsposition in dem Schrank in eine herausgezogene Ruheposition außerhalb des Schranks bewegbar ist, wobei der Haltemechanismus bewirkt, dass die Tragschale nach oben gehoben wird, wenn sie aus der Betriebsposition in die herausgezogene Position bewegt wird.

2. Schrank nach Anspruch 1, wobei das Oberteil des Schranks (1) eine Zugangsöffnung (3) in seiner Seite umfasst, durch die die Tragschale (5) gleitend herausgezogen werden kann.

3. Schrank nach Anspruch 1 oder Anspruch 2, wobei der Haltemechanismus eine Nockenfläche (10) entweder an der Tragschale (5) oder dem Schrank (1) umfasst, die angeordnet ist, um mit einer Nockenstößelfläche (14) an dem anderen in Eingriff zu treten, um die Tragschale anzuheben, wenn sie nach außen bewegt wird.

4. Schrank nach Anspruch 3, wobei die Nockenfläche eine zur Horizontalen geneigte Rampenfläche (10) entweder an der Tragschale (5) oder dem Schrank (1) umfasst, die angeordnet ist, um mit dem anderen in Eingriff zu treten, um die Tragschale anzuheben, wenn sie nach außen bewegt wird.

5. Schrank nach einem der Ansprüche 1 bis 4, umfassend einen Stoppmechanismus (13), um die vollständige Lösung der Tragschale (5) aus dem Schrank (1) zu verhindern.

6. Schrank nach Anspruch 5, wobei der Stoppmechanismus eine oder mehrere Ansätze (13) umfasst, die mit den Seiten des Schranks in Eingriff treten können.

7. Schrank nach Anspruch 5 oder Anspruch 6, wobei der Stoppmechanismus (13) ermöglicht, dass die Tragschale in einer im wesentlichen vertikalen Position außerhalb des Schranks gehalten wird, wobei sie vom Oberteil des Schranks herabhängt.

8. Schrank nach einem der Ansprüche 1 bis 7, wobei die Tragschale ein elektrisches Verbindungsstück umfasst, das automatisch mit einem passenden Verbindungsstück an dem Schrank in Eingriff tritt, wenn die Tragschale in ihre Betriebsposition bewegt wird.

9. Schrank nach einem der Ansprüche 1 bis 8, wobei die Tragschale (5) eine oder mehrere elektrische Komponenten (4) umfasst, die daran angeordnet sind.

10. Schrank nach Anspruch 9, wobei die Tragschale (5) einen oder mehrere Ventilatoren (4) umfasst, die daran angeordnet sind.

## Revendications

1. Armoire pour équipement (1) ayant un haut (2) qui comprend un plateau pour équipement sensiblement horizontal (5) pouvant être enlevé du haut de l'armoire, **caractérisée par**
un mécanisme de support (7, 10) à l'aide duquel le plateau (5) est mobile de manière coulissante à travers un élément latéral de l'armoire depuis une position opérationnelle dans l'armoire jusqu'à une position retirée non opérationnelle hors de l'armoire, le mécanisme de support faisant se soulever le plateau vers le haut lorsqu'on le déplace de la position opérationnelle à la position retirée.

2. Armoire selon la revendication 1, dans laquelle le haut de l'armoire (1) comprend une ouverture d'accès (3) au niveau de son côté, à travers laquelle le plateau (5) peut être retiré de manière coulissante.

3. Armoire selon la revendication 1 ou la revendication 2, dans laquelle le mécanisme de support comprend une surface de came (10) sur un élément parmi le plateau (5) et l'armoire (1) et agencée pour venir en prise avec une surface de galet de poussoir (14) sur l'autre élément pour soulever le plateau lorsqu'on le fait se déplacer vers l'extérieur.

4. Armoire selon la revendication 3, dans laquelle la surface de came comprend une surface de rampe (10) inclinée à l'horizontale sur un élément parmi le plateau (5) et l'armoire (1) et agencée pour venir en prise avec l'autre élément pour soulever le plateau lorsqu'on le fait se déplacer vers l'extérieur.

5. Armoire selon l'une quelconque des revendications 1 à 4, comprenant un mécanisme butoir (13) pour empêcher la déconnexion complète du plateau (5) par rapport à l'armoire (1).

6. Armoire selon la revendication 5, dans laquelle le mécanisme butoir comprend une ou plusieurs saillies (13) pouvant venir en prise avec les côtés de l'armoire.

7. Armoire selon la revendication 5 ou la revendication 6, dans laquelle le mécanisme butoir (13) permet au plateau d'être supporté dans une position sensiblement verticale hors de l'armoire, pendant depuis le haut de l'armoire.

8. Armoire selon l'une quelconque des revendications 1 à 7, dans laquelle le plateau comprend un connecteur électrique qui vient automatiquement en prise avec un connecteur correspondant sur l'armoire lorsque le plateau est déplacé dans sa position opérationnelle.

9. Armoire selon l'une quelconque des revendications 1 à 8, dans laquelle le plateau (5) comprend un ou plusieurs composants électriques (4) disposés sur celui-ci.

10. Armoire selon la revendication 9, dans laquelle le plateau (5) comprend un ou plusieurs ventilateurs (4) disposés sur celui-ci.
